# EUROPEAN PATENT APPLICATION

(11) **EP 1 280 270 A2**
(43) Date of publication of application: **29.01.2003**
(21) Application number: 01308045.2
(22) Date of filing: 21.09.2001
(51) Int. Cl.: H03F 1/32

(54) **Base-station amplifier device**

(30) Priority: 04.07.2001 JP 2001203085
(71) Applicant: Hitachi Kokusai Electric Inc., Tokyo (JP)
(72) Inventor: Nanao, Yoshinari, c/o Hitachi Kokusai, Nakano-ku, Tokyo (JP); Yamakawa, Junichiro, c/o Hitachi Kokusai, Nakano-ku, Tokyo (JP)
(74) Representative: Haley, Stephen

(57) **Abstract**

A base-station amplifier device for use in amplifying at least one channel to be transmitted from a base station is provide to solve deterioration in radio characteristic caused due to variation of peak signal. The base-station amplifier device comprises: amplitude limiting means for amplitude-limiting a base band signal every said channel; high-frequency modulating means for performing a high-frequency modulation on an output from said amplitude limiting means every said channel; adding means for adding outputs from all of said high-frequency modulating means; amplifying means for amplifying an output from said adding means; and amplitude controlling means for controlling said amplitude limiting means based on characteristic of said amplifying means.

## Description

The present invention relates to a base-station amplifier device for use in controlling an amplitude limitation (clipping) on a base band signal transmitted from a base station, when peak power and the number of channels in multiple signals to be transmitted in a CDMA (Code Division Multiple Access) mode are increased.

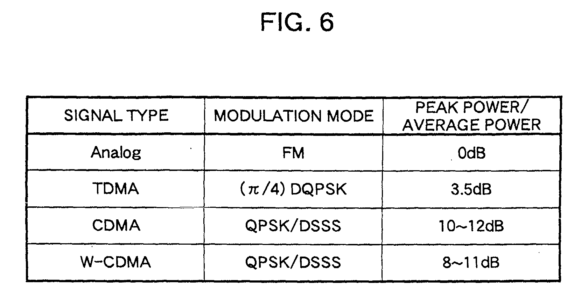

Recently, with a development of a mobile communication system, a modulation mode has varied from FM (Frequency Modulation) to TDMA (Time Division Multiple Access) and to CDMA. In particular, the CDMA mode begins to be populated due to its ability of fast data communication and high insusceptibility to interference. Further, a ratio of peak power/average power in a signal source becomes larger with changing of the modulation mode. Fig. 6 is a table showing characteristics in peak power/average power of various modulation modes. As shown in Fig. 6, the FM mode is 0dB as peak power/average power and the TDMA mode is 3.5dB while the W-CDMA mode is 8-11dB and the CDMA mode is about 10-12dB. Also, if RF signals of more than and equal to 2 channels are commonly-amplified, carrier signals are increased and simultaneously peak powers are similarly increased.

It is necessary to linearly amplify such increased peak powers by using an amplifier of the base station. When the amplifier outputs 20 watts at its average power for example, it must output 200-320 watts at its peak power as clear from the table in Fig. 6.

However, if output of the amplifier in the above-mentioned example is less than 200 watts at most, it is impossible to perform a linear amplification so that a distortion is generated with deterioration of radio characteristic. In the CDMA mode, since transmitting power is increased by increasing the number of channels to be multiplexed, peak power increases as traffic increases. In particular, there is a tendency to largely vary a design of the amplifier in response to magnitude in peak signal to be inputted thereto.

Therefore, the present invention is accomplished in view of the above-mentioned problems. An object of the present invention is to provide a base-station amplifier device for use in amplifying at least one channel to be transmitted from a base station, which comprises: amplitude limiting means for amplitude-limiting a base band signal every the channel; high-frequency modulating means for performing a high-frequency modulation on an output from the amplitude limiting means every the channel; adding means for adding outputs from all of the high-frequency modulating means; amplifying means for amplifying an output from the adding means; and amplitude controlling means for controlling the amplitude limiting means based on characteristic of the amplifying means.

With the base-station amplifier device thus configured, it is possible to suppress a distortion in output from the amplifying means at the base station by performing an amplitude control of peak in a transmitting base band signal from the base station.

In the base-station amplifier device, the amplitude controlling means is characterized by controlling the amplitude limiting means only when the number of the channels exceeds a preset number.

With this configuration, it is possible to amplify high peak signal during low traffic and lower deterioration in radio characteristic caused due to variation of peak signal during high traffic and high transmitting power.

Furthermore, in the base-station amplifier device according to the present, on an input side or an output side of the amplifying means, there can be provided detecting means. In this case, the amplitude controlling means is characterized by controlling the amplitude limiting means based on characteristic of the amplifying means and output from the detecting means when output from the detecting means exceeds a threshold value based on characteristic of the amplifying means.

With this configuration, it is possible to suppress a distortion in output from the amplifying means of the base station by performing an amplitude control of peak in the transmitting base band signal of the base station.

In the Drawings;
Fig. 1 is a block diagram showing an example of configuration of a base-station amplifier device according to a first embodiment;
Fig. 2 is a graph showing an example of input/output characteristic of an amplifier;
Fig. 3 is a block diagram showing an example of configuration of a base-station amplifier device according to a third embodiment;
Fig. 4 is a graph showing CCDF (Complementary Cumulative Distribution Function) characteristic and its different characteristics depending on whether an amplitude limitation being present or absent;
Fig. 5 is a graph showing differences in power spectrum waveform outputted from the amplifier depending on whether the amplitude limitation is present or absent; and
Fig. 6 is a table showing characteristics of peak power/average power of various modulation modes.

Hereinafter, preferred embodiments of the present invention will be described in detail with reference to the accompanying drawings.

### EMBODIMENT 1:

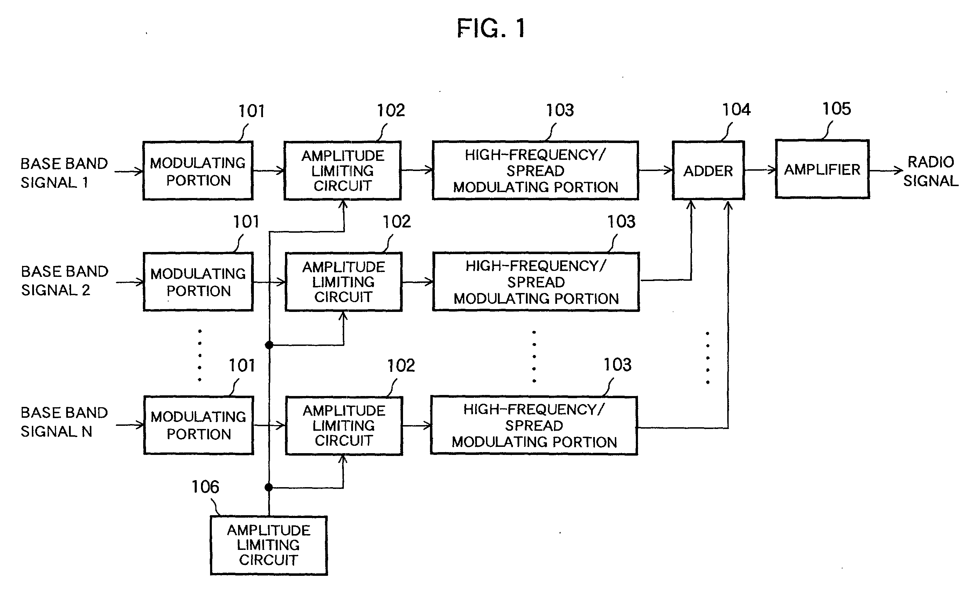

Fig. 1 is a block diagram showing an example of configuration of a base-station amplifier device according to a first embodiment of the present invention. As shown in Fig. 1, the base-station amplifier device comprises: a modulating portion 101; an amplitude limiting circuit 102; a high-frequency converting/spread modulating portion 103; an adder 104; an amplifier 105; and an amplitude controlling circuit 106. In this embodiment, there are N channels, i.e., channels 1-N, available for the base-station amplifier device as shown in Fig. 1, and base-band signals 1-N are allocated to the channels 1-N, respectively. Also, there are prepared N sets of the modulating portions 101, amplitude limiting circuits 102 and high-frequency converting/spread modulating portions 103 for the N channels in a one-to-one manner. Incidentally, the amplitude limiting circuit 102 is also referred to as "amplitude limiting means", the high-frequency converting/spread modulating portion 103 is also referred to as "high-frequency modulating means", the amplifier 105 is also referred to as "amplifying means" and the amplitude controlling circuit 106 is also referred to as "amplitude controlling means" in the present application.

The operation of this base-station amplifier device will be described.

In each channel, the modulating portion 101 orthogonal-modulates a base band signal inputted thereto, and then outputs the resultant signal as a base band modulated signal to the amplitude limiting circuit 102. The amplitude limiting circuit 102 amplitude-limits the base band modulated signal according to amplitude limiting characteristic from the amplitude controlling circuit 106, and outputs the resultant signal as the base band amplitude-limited signal to the high-frequency converting/spread modulating portion 103.

Next, in each channel, the high-frequency converting/spread modulating portion 103 subjects the base band amplitude-limited signal to spread modulation and high-frequency conversion. Thus, respective resultant signals outputted from all of the high-frequency converting/spread modulating portions 103 in the N channels are inputted as high-frequency signals 1-N to the adder 104 in parallel. The adder 104 adds N high-frequency signals together and outputs the resultant signal as a multiple signal to the amplifier 105. The amplifier 105 amplifies its signal up to a transmitting output and outputs the resultant amplified signal as a radio signal outside. It would be appreciated that the amplitude controlling circuit 10 6 can function to output the preset amplitude limiting characteristic of the amplifier 105 to the amplitude limiting circuit 102.

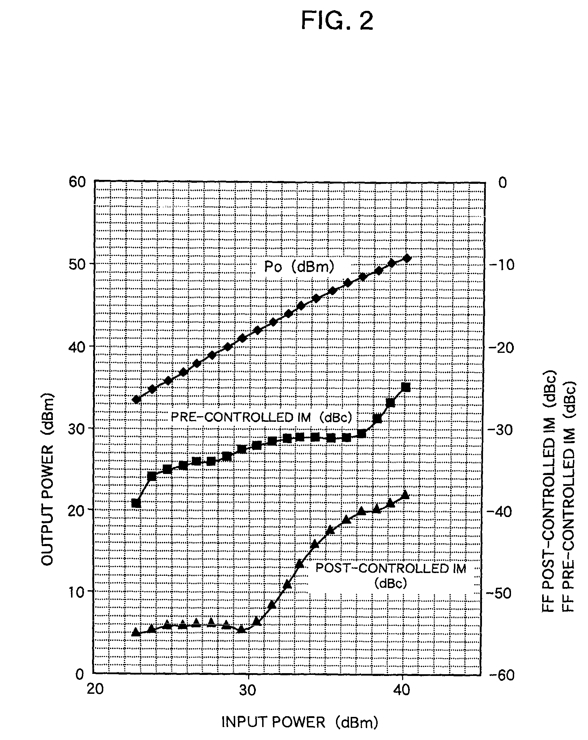

Next, a specific amplitude limiting characteristic outputted from the amplitude controlling circuit 106 will be described with reference to Fig. 2. Fig. 2 is a graph showing an example of input/output characteristic of the amplifier. In Fig. 2, an abscissa denotes an input power (dBm), a left ordinate denotes an output power (dBm), and a right ordinate denotes IM(intermodulation distortion) characteristic (dBc). Po is output power against input power in the amplifier 105. IM3 expresses IM characteristic of the amplifier 105 singularly. IM5 expresses IM characteristic of an FF (feed-forward) amplifier.

In general, a practical range of the IM characteristic is less than or equal to -30dBc. Since the FF amplifier can compensate for a distortion of about 25dB, the IM characteristic of the FF amplifier becomes about -55dBc as shown in Fig. 2. On the other hand, if a peak power/an average power is 10dB, the IM characteristic deteriorates at 28dBm or more of the input power of the amplifier 105 as indicated by the FF post-controlled IM characteristic in Fig. 2. Accordingly, if a threshold value in the input power is 28dBm, the amplitude controlling characteristic exhibits an ability to perform the amplitude limitation in response to the input power-IM characteristic in a range more than or equal to this threshold value. The amplitude controlling circuit 106 outputs this amplitude controlling characteristic to the amplitude limiting circuit 102.

In this embodiment, the amplitude limiting circuit 102 is arranged on a posterior stage of the modulating portion 101, but it may also be possible to similarly operate the base-station amplifier device even if the amplitude limiting circuit 102 is arranged on an anterior stage of the modulating portion 101.

### EMBODIMENT 2:

A base-station amplifier device according to a second embodiment of the present invention is configured similarly to that as shown in Fig. 1. In this second embodiment, the amplitude controlling circuit 106 conducts a determination for the amplitude control according to the number of channels. When the number of channels is small, i.e., at the time of a low traffic, transmitting power becomes small so that the amplitude controlling circuits 106 instructs the amplitude limiting circuits 102 not to perform an amplitude limitation on peak signal. On the contrary, when the number of channels is increased, i.e., at the time of a high traffic, the transmitting power is increased so that the amplitude controlling circuits 106 instructs the amplitude limiting circuits 102 to perform the amplitude limitation on peak signal because a backoff of the amplifier 105 is decreased.

### EMBODIMENT 3:

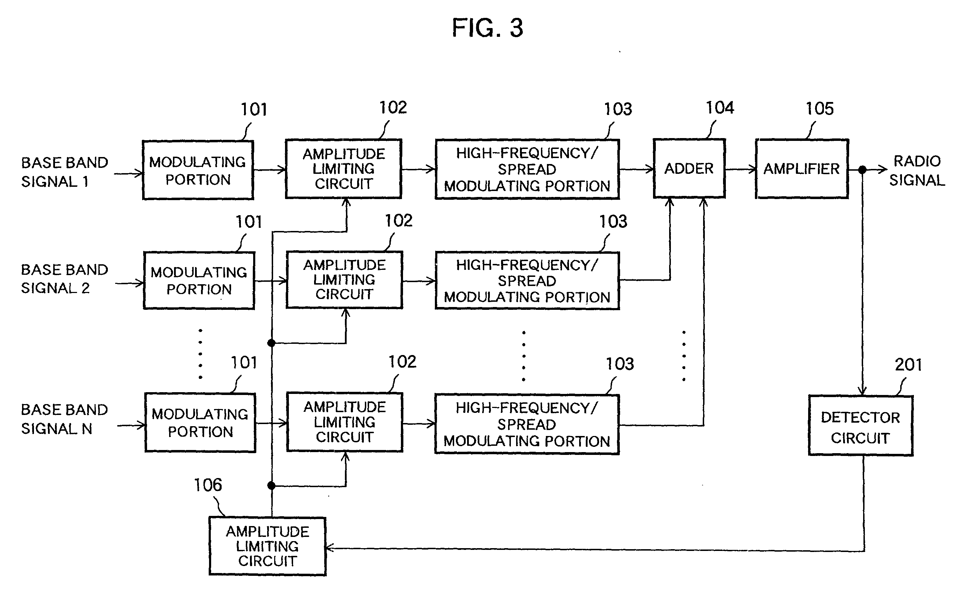

Fig. 3 is a block diagram showing an example of configuration of a base-station amplifier device according to a third embodiment of the present invention. In Figs. 1 and 3, the same or like numbers indicates the same or like parts and therefore explanations of such parts are omitted hereinafter. In particular, this third embodiment further comprises a detector circuit 201 arranged on a posterior stage of the amplifier 105. Incidentally, the detector circuit 201 is also referred to as "detecting means" in the present application.

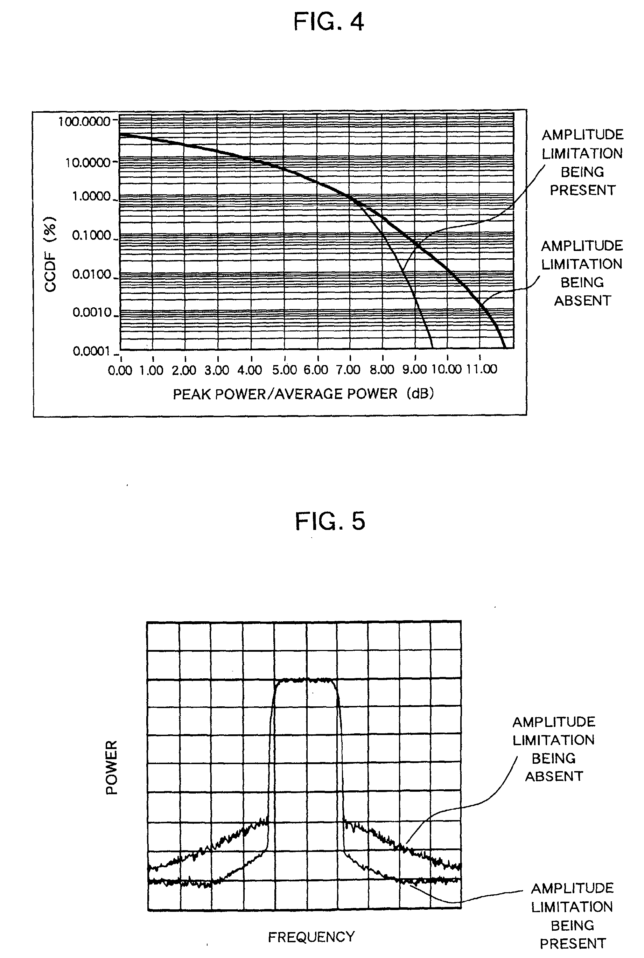

The operation of this detector circuit 201 will be described with reference to Figs. 4 and 5. Fig. 4 is a graph showing CCDF (Complementary Cumulative Distribution Function) characteristic and its different characteristics depending on whether the amplitude limitation being present or absent. In Fig. 4, an abscissa denotes peak power/average power while an ordinate denotes possibility exceeding the peak power/average power in the abscissa. Also, Fig. 5 is a graph showing differences in power spectrum waveform outputted from the amplifier depending on whether the amplitude limitation is present or absent. In Fig. 5, an abscissa denotes frequency while an ordinate denotes power. Graphs as shown in Figs. 4 and 5 are plotted during operation of the CDMA communication.

When an output power of the amplifier 105 is in a high state, the amplifier output is distorted by a non-linear portion of the amplifier 105, thereby resulting in a power spectrum without the amplitude limitation as shown in Fig. 5. The detector circuit 201 performs a detection on output from the amplifier 105 and then outputs an obtained output power from amplifier 105 to the amplitude controlling circuit 106. The amplitude controlling circuit 106 outputs as a threshold value the amplifier output power near which the distortion is generated to the amplitude limiting circuit 102. The amplitude limiting circuit 102 amplitude-limits peaks which, among the base band modulated signals, exceeds the threshold value.

Next, a specific amplitude limiting characteristic due to the amplitude controlling circuit 106 will be described in detail. Similarly to that of the first embodiment, by using the input/output characteristic of the amplifier 105 as shown in Fig. 2, a threshold value is determined against an output power from the amplifier 105. If an output power obtained from the detector circuit 201 does exceed this threshold value, the amplitude controlling circuit 106 instructs the amplitude limiting circuit 102 to perform the amplitude limitation. At this time, a control amount of the amplitude limitation in response to the input power-IM characteristic as shown in Fig. 2 is also outputted to the amplitude limiting circuit 102.

As is shown in the CCDF characteristic when peak signal is not amplitude-limited, the peak power/average power is 12dB at the maximum. When peak power is high, a spectrum waveform outputted from the amplifier is distorted with deterioration of radio characteristic. Consequently, the CCDF characteristic becomes a characteristic with an amplitude limitation as shown in Fig. 4. As a result, the power spectrum becomes a characteristic with an amplitude limitation as shown in Fig. 5 and it is possible to suppress distortion.

In this third embodiment, there is arranged the detector circuit 201 on the posterior stage of the amplifier 105, but it is possible to achieve a similar resultant operation even if the detector circuit 201 is arranged on an anterior stage of the amplifier 105. Further, in this third embodiment, the amplitude limiting circuit 102 is arranged on the posterior stage of the modulating portion 101, but it is possible to achieve a similar resultant operation even if the amplitude limiting circuit 102 is arranged on the anterior stage of the modulating portion 101.

As described above, in accordance with the present invention, it is possible to amplify high peak signal during low traffic and lower deterioration in radio characteristic caused due to variation of peak signal during high traffic and high transmitting power. As a result, it is possible to achieve a low power consumption, an increased service-area by implementing a high power and a high stabilization in distortion control.

## Claims

1. A base-station amplifier device for use in amplifying at least one channel to be transmitted from a base station, comprising:
amplitude limiting means for amplitude-limiting a base band signal every said channel;
high-frequency modulating means for performing a high-frequency modulation on an output from said amplitude limiting means every said channel;
adding means for adding outputs from all of said high-frequency modulating means;
amplifying means for amplifying an output from said adding means; and
amplitude controlling means for controlling said amplitude limiting means based on characteristic of said amplifying means.

2. A base-station amplifier device as claimed in claim 1, wherein said amplitude controlling means controls said amplitude limiting means only when the number of said channels exceeds a preset number.

3. A base-station amplifier device as claimed in claim 1, further comprising detecting means arranged on an input side or an output side of said amplifying means, wherein said amplitude controlling means controls said amplitude limiting means based on characteristic of said amplifying means and output from said detecting means when output from said detecting means exceeds a threshold value based on characteristic of said amplifying means.
